# FASCICULE DE BREVET EUROPEEN

(11) **EP 4 047 954 B1**
(45) Date de publication et mention de la délivrance du brevet: **30.10.2024**
(21) Numéro de dépôt: 22157902.2
(22) Date de dépôt: 22.02.2022
(51) Int. Cl.: H04R 17/00

(54) **HAUT-PARLEUR MEMS ET PROCÉDÉ DE FABRICATION D'UN TEL HAUT-PARLEUR**
MEMS-LAUTSPRECHER UND VERFAHREN ZUR HERSTELLUNG EINES SOLCHEN LAUTSPRECHERS
MEMS LOUDSPEAKER AND METHOD FOR MANUFACTURING SUCH A LOUDSPEAKER

(30) Priorité: 23.02.2021 FR 2101743
(43) Date de publication de la demande: 24.08.2022
(73) Titulaire: Commissariat à l'Energie Atomique et aux Energies Alternatives, 75015 Paris (FR)
(72) Inventeur: LIECHTI, Romain, 38054 GRENOBLE CEDEX 09 (FR)
(74) Mandataire: Cabinet Camus Lebkiri

(56) Documents cités:
- US-A1- 2017 094 418
- US-A1- 2017 325 030
- KOMMEPALLI HAREESH KUMAR REDDY: "DESIGN, MODELING AND OPTIMIZATION OF PIEZOELECTRIC ACTUATORS", DISSERTATION IN MECHANICAL ENGINEERING, 31 May 2010 (2010-05-31), pages 1 - 138, XP055858393, Retrieved from the Internet <URL:https://etda.libraries.psu.edu/files/final_submissions/2190> [retrieved on 20211105]

## Description

### DOMAINE TECHNIQUE DE L'INVENTION

La présente invention concerne un haut-parleur miniaturisé adapté pour être intégré dans les dispositifs portables tels que les ordinateurs portables, les téléphones portables, les écouteurs sans fils, etc. L'invention concerne également un procédé de microfabrication d'un tel haut-parleur.

L'invention trouve des applications dans le domaine de l'acoustique pour la génération d'ondes sonores audibles par l'oreille humaine. Elle trouve en particulier des applications dans le domaine de l'acoustique dédié aux dispositifs portables nécessitant des haut-parleurs miniaturisés.

### ARRIERE-PLAN TECHNOLOGIQUE DE L'INVENTION

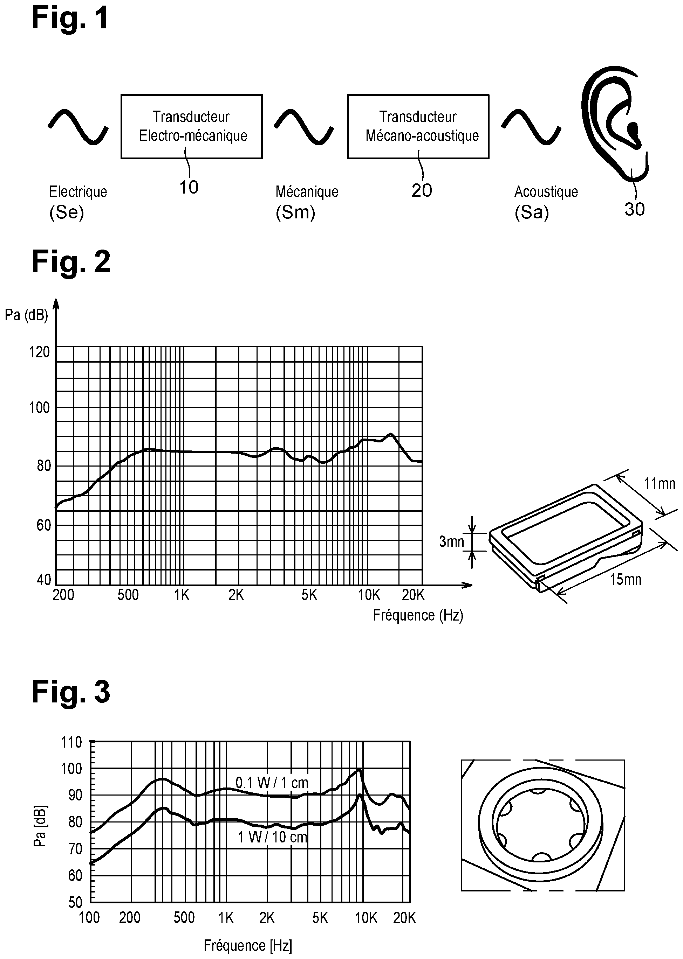

Il est connu, en acoustique, d'utiliser un haut-parleur pour générer des ondes sonores audibles par l'oreille humaine. Un haut-parleur est un appareil conçu pour transformer un signal électrique en pression acoustique, comme représenté de façon fonctionnelle sur la figure 1. Un haut-parleur est un transducteur électro-mécano-acoustique comportant :
- un premier transducteur électro-mécanique 10 qui convertit la tension d'un signal électrique (Se) en un signal mécanique (Sm) tel qu'un déplacement, et
- un second transducteur mécano-acoustique 20 qui convertit ce déplacement (Sm) en une pression acoustique (Sa), audible par l'oreille humaine 30. Ce second transducteur mécano-acoustique 20 est généralement une membrane acoustique, couplée à l'air ambiant.

Depuis plusieurs années, avec le développement des dispositifs portables comme les ordinateurs portables, les tablettes, les téléphones portables et même les écouteurs sans fils, on cherche à miniaturiser les haut-parleurs afin qu'ils puissent être intégrés dans ces dispositifs portables. Cependant dans ce contexte de miniaturisation, il est difficile de réaliser un haut-parleur présentant de bonnes performances.

En effet, un bon haut-parleur, c'est-à-dire un haut-parleur ayant de bonnes performances, reproduit toutes les fréquences de la bande audio audibles par l'oreille humaine (20 Hz à 20 kHz) à la même amplitude, avec un taux de distorsion faible. Dans la pratique, la fréquence la plus basse à laquelle un haut-parleur produit efficacement du son est déterminée par la fréquence de résonance du transducteur mécano-acoustique. Or, dans un contexte de miniaturisation, le système d'actionnement de la membrane est plus rigide et la masse de la membrane est plus faible, ce qui augmente la fréquence de résonance du système et réduit donc sa bande passante.

De plus, le niveau de pression acoustique rayonné par un haut-parleur dépend du volume d'air accéléré par ledit haut-parleur et ce volume d'air accéléré dépend du produit de la surface de la membrane du haut-parleur et du déplacement maximum de cette membrane. Dans un contexte de miniaturisation, la surface de la membrane est grandement réduite ; un déplacement important de la membrane est donc nécessaire pour obtenir un niveau de pression satisfaisant. Un exemple du niveau de pression acoustique (Pa) rayonné par un haut-parleur mesurant 11 x 15 x 3 mm³ est représenté sur la figure 2. Bien que la pression rayonnée (Pa) soit d'environ 85 dB sur une large plage de fréquence, l'encombrement d'un tel haut-parleur est de moins en moins compatible avec les dimensions des appareils portables dont la tendance est d'être de plus en plus petits et minces. En effet, non seulement les fabricants de dispositifs portables cherchent à réaliser des dispositifs de plus en plus petits, mais en plus ils cherchent à implanter de plus en plus de fonctionnalités au sein d'un même dispositif portable, ce qui implique une diminution de l'encombrement de chacun des systèmes permettant la mise en oeuvre de ces fonctionnalités.

Plusieurs technologies sont actuellement utilisées pour l'actionnement des membranes de haut-parleurs. L'une de ces technologies est la transduction électromagnétique qui permet d'atteindre des déplacements relativement grands de la membrane. La grande majorité des haut-parleurs actuels sont équipés de transducteurs électromagnétiques. Un exemple, représenté sur la figure 3, d'un haut-parleur à actionnement électromagnétique et de son niveau de pression acoustique (Pa) est décrit dans l'article « High Fidelity MEMS Electrodynamic Micro-Speaker Characterization » de E Sturtzer, I Shahosseini, G Pillonnet, E Lefeuvre et G Lemarquand, Journal of Applied Physics, American Institute of Physics, 2013, pp.9, ffhal-01103610. Cependant, bien qu'un tel haut-parleur à transducteurs électromagnétiques présente de bonnes performances, ses dimensions ne permettent pas une intégration dans les dispositifs portables actuels. En outre, le fait d'utiliser un aimant dans le système d'actionnement rend la fabrication de ce type de haut-parleur incompatible avec les procédés de microfabrication.

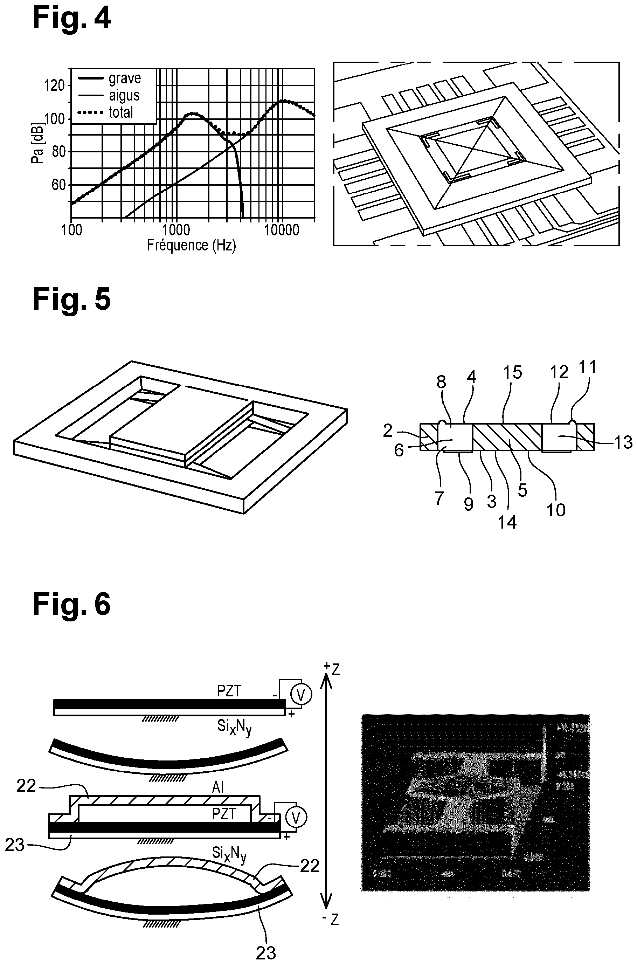

Une autre technologie connue d'actionnement de la membrane montrant des performances notables est la transduction piézoélectrique. Bien que cette technologie de transduction piézoélectrique ne confère pas de grands déplacements de la membrane, elle présente l'avantage d'être compatible avec les procédés de microfabrication. En effet, en utilisant l'effet bilame et en positionnant l'actionneur piézoélectrique sur la membrane, des performances comparables à celle des transducteurs électromagnétiques sont atteignables. Un exemple d'un haut-parleur à actionnement piézoélectrique microfabriqué et de son niveau de pression acoustique (Pa) est représenté sur la figure 4 et décrit dans l'article intitulé « Novel Type of MEMS Loudspeaker Featuring Membrane-Less Two-Way Sound Génération » de F Stoppel, F Niekiel, T Giese, S Gu-Stoppel, A Männchen, J Nowak, D Beer, et B Wagner, AES, New York, 2017, 6. Cependant, bien qu'un tel haut-parleur microfabriqué offre des performances intéressantes, il requière une membrane d'environ 10 x 10 mm², ce qui est trop encombrant pour les dispositifs portables actuels. De plus, la membrane de ce type de haut-parleur n'est pas indéformable, ce qui est une propriété nécessaire pour assurer une bonne qualité audio à long terme.

Le brevet US 2017/0094418 A1 décrit une variante d'un haut-parleur à actionneurs piézoélectriques, dans lequel les actionneurs piézoélectriques sont déportés de la membrane, comme représenté sur la figure 5. Dans cet exemple, les actionneurs 9 ne sont pas directement sur la membrane 15. Ils sont déportés, ce qui assure un mouvement pistonique de la membrane et permet de s'affranchir des problèmes des haut-parleurs à transducteur piézoélectrique classiques. Ce haut-parleur a l'avantage de requérir une surface de silicium moindre et d'offrir une empreinte du haut-parleur réduite. Cependant, malgré ces avantages, la technologie décrite dans ce brevet ne permet pas de grands déplacements de la membrane, ce qui engendre une faible bande passante.

Il a été décrit, par ailleurs, un amplificateur de déplacement permettant d'améliorer le déplacement d'un actionneur piézoélectrique bilame. Cet amplificateur de déplacement, décrit sous le nom d'«uniflex » par H Kommepalli dans le document «Design, Modeling and Optimization of Piezoelectric Actuators », PhD Thesis, The Pennsylvania State University, 2010, p 138, propose de coupler une capsule en aluminium avec un actionneur piézoélectrique bilame classique de sorte à obtenir un déplacement plus important. Un schéma de fonctionnement de cet amplificateur de déplacement est représenté sur la figure 6. Cet amplificateur de déplacement comporte une capsule flexible en aluminium 22, fixée latéralement sur l'actionneur piézoélectrique bilame 23. Sous l'effet de la tension d'actionnement, symbolisée par la tension V, l'actionneur piézoélectrique bilame 23 fléchit dans la direction -z, entraînant mécaniquement une flexion de la capsule en aluminium 22 dans la direction opposée +z. Le moment de flexion de la capsule en aluminium 22 permet ainsi d'augmenter le déplacement de l'actionneur piézoélectrique bilame 23, ce qui offre un déplacement plus grand tout en conservant la surface de l'actionneur.

### RESUME DE L'INVENTION

Pour répondre aux problèmes évoqués ci-dessus de performances des haut-parleurs miniaturisés adaptés pour être installés dans des dispositifs portables, le demandeur propose un haut-parleur MEMS dans lequel un actionneur bilame est couplé à une capsule d'amplification intégrant une membrane acoustique.

Le terme « MEMS » est une abréviation de l'expression anglaise Microelectromechanical systems, ou systèmes micro-électromécaniques en français, qui sont des dispositifs miniaturisés à élément(s) mobile(s) ou vibrant(s) utilisés généralement comme actionneurs ou transducteurs. Un haut-parleur MEMS est donc un haut-parleur miniature adapté pour être intégré dans un dispositif portable tel qu'un téléphone portable ou un écouteur sans fil.

Selon un premier aspect, l'invention concerne un haut-parleur MEMS adapté pour générer des ondes sonores audibles, comportant un système d'actionnement bilame s'étendant suivant un premier plan, comportant en outre une capsule d'amplification comprenant :
- une membrane s'étendant suivant un second plan, parallèle au premier plan, ladite membrane comportant une zone intérieure rigide et une zone extérieure flexible, et
- une paroi de couplage rigide, fixée en périphérie du système d'actionnement bilame pour rendre la zone extérieure flexible de la membrane solidaire dudit système d'actionnement et, sous l'effet d'une tension électrique d'actionnement appliquée au système d'actionnement bilame, générer sur la paroi de couplage un moment de flexion entraînant une translation de la zone intérieure rigide de ladite membrane.

Un tel haut-parleur MEMS présente l'avantage d'augmenter le déplacement au sein du haut-parleur tout en offrant les avantages des transducteurs piézoélectriques en termes de performances audio et de facilité à être microfabriqués.

Outre les caractéristiques qui viennent d'être évoquées dans le paragraphe précédent, le haut-parleur MEMS selon un aspect de l'invention peut présenter une ou plusieurs caractéristiques complémentaires parmi les suivantes, considérées individuellement ou selon toutes les combinaisons techniquement possibles :
- le système d'actionnement bilame comporte au moins un actionneur piézoélectrique intégré à une couche d'un matériau élastique.
- la capsule d'amplification et le système d'actionnement bilame sont de formes circulaires avec, au repos, un diamètre extérieur identique.
- le système d'actionnement bilame est de forme annulaire.
- la capsule d'amplification a une forme de disque et le système d'actionnement bilame comporte au moins une paire d'actionneurs de forme rectangulaire, les actionneurs de chaque paire étant positionnés de façon diamétralement opposée.
- la zone intérieure rigide de la membrane présente un rayon compris entre environ 10 à 60% du rayon total de la membrane.
- la membrane comporte un diamètre compris dans un intervalle allant d'environ 100 µm à quelques centimètres.
- la membrane et la paroi de couplage de la capsule d'amplification sont réalisées d'une seule pièce dans un même matériau.
- la membrane et la paroi de couplage de la capsule d'amplification sont réalisées dans des matériaux différents, la paroi de coupage étant collée à l'extrémité extérieure de la zone extérieure flexible de la membrane.

Un autre aspect de l'invention concerne un procédé de microfabrication du haut-parleur MEMS tel que défini ci-dessus, ce procédé comportant les étapes suivantes:
a) Choix d'un substrat ;
b) Dépôt, sur une face avant du substrat, d'au moins une couche d'oxydation et une couche de polysilicium ;
c) Gravure, sur la face avant, de la paroi de couplage par photolithographie ;
d) Dépôt d'au moins une couche piézoélectrique pour former l'actionneur ;
e) Gravure, au centre de la couche piézoélectrique, d'une cavité ;
f) Dépôt d'un masque de protection recouvrant partiellement la cavité et la surface de la couche piézoélectrique ;
g) Dépôt de pistes et/ou plots de connexion dans des zones non recouvertes par le masque de protection ;
h) Dépôt d'une membrane en appui sur la paroi de couplage ;
i) Gravure, sur une face arrière du substrat, d'un plot d'ancrage.

Ce procédé peut présenter une ou plusieurs caractéristiques complémentaires parmi les suivantes, considérées individuellement ou selon toutes les combinaisons techniquement possibles :
- la couche piézoélectrique est une couche de matériau piézoélectrique associée à deux couches de métaux inertes adaptées pour constituer des électrodes.
- la cavité, gravée à l'étape e), comporte une dénivellation conçue pour constituer un accès électrique à la couche piézoélectrique.
- la membrane est déposée sur une couche sacrificielle recouvrant une zone s'étendant à l'intérieur de la paroi de couplage, la membrane étant munie d'orifices de vidage adaptés pour vider ladite couche sacrificielle.

### BREVE DESCRIPTION DES FIGURES

D'autres avantages et caractéristiques de l'invention apparaîtront à la lecture de la description qui suit, illustrée par les figures dans lesquelles :
La figure 1, déjà décrite, représente schématiquement le fonctionnement électro-mécano-acoustique d'un haut-parleur ;
La figure 2, déjà décrite, représente une vue schématique d'un haut-parleur miniature classique intégrant les dispositifs portables actuels et une courbe de la pression rayonnée, en fonction de la fréquence, de ce haut-parleur ;
La figure 3, déjà décrite, représente une vue schématique d'un haut-parleur microfabriqué et une courbe de la pression acoustique, en fonction de la fréquence, de ce haut-parleur ;
La figure 4 représente une vue schématique d'un haut-parleur microfabriqué à actionnement piézoélectrique et une courbe de la pression acoustique, en fonction de la fréquence, de ce haut-parleur ;
La figure 5 représente des vues schématiques de profil et en coupe d'un haut-parleur à actionnement piézoélectrique dont la membrane est déportée ;
La figure 6 représente des vues fonctionnelles d'un amplificateur de déplacement comportant une capsule en aluminium surmontant un actionneur piézoélectrique ;
La figure 7 représente une vue schématique en demi-coupe d'un haut-parleur MEMS selon l'invention, en position de repos ;
La figure 8 représente une vue schématique en demi-coupe du haut-parleur MEMs selon l'invention, en fonctionnement ;
La figure 9 représente différentes positions du haut-parleur MEMS de la figure 7 suivant la tension appliquée à l'actionneur ;
La figure 10 représente une vue schématique en demi-coupe d'un exemple de dimensions du haut-parleur MEMS de la figure 7 ;
La figure 11 représente des vues schématiques de dessous de plusieurs modes de réalisation du haut-parleur MEMS selon l'invention ;
La figure 12 représente une vue schématique en coupe d'un exemple de haut-parleur MEMS selon l'invention ;
La figure 13 représente schématiquement un exemple de déplacement de la membrane d'un haut-parleur MEMS selon la figure 12 ;
La figure 14 représente des exemples de courbes montrant la pression acoustique et le déplacement de la membrane d'un haut-parleur MEMS selon l'invention ;
La figure 15 représente schématiquement la vitesse de la membrane et la pression acoustique d'un exemple de haut-parleur MEMS selon l'invention ; et
La figure 16 et la figure 17 représentent un exemple de procédé de microfabrication d'un haut-parleur MEMS selon l'invention.

### DESCRIPTION DETAILLEE

Un exemple de réalisation d'un haut-parleur MEMS microfabricable, configuré pour être insérable dans un dispositif portable, est décrit en détail ci-après, en référence aux dessins annexés. Cet exemple illustre les caractéristiques et avantages de l'invention. Il est toutefois rappelé que l'invention ne se limite pas à cet exemple.

Sur les figures, les éléments identiques sont repérés par des références identiques. Pour des questions de lisibilité des figures, les échelles de taille entre éléments représentés ne sont pas respectées.

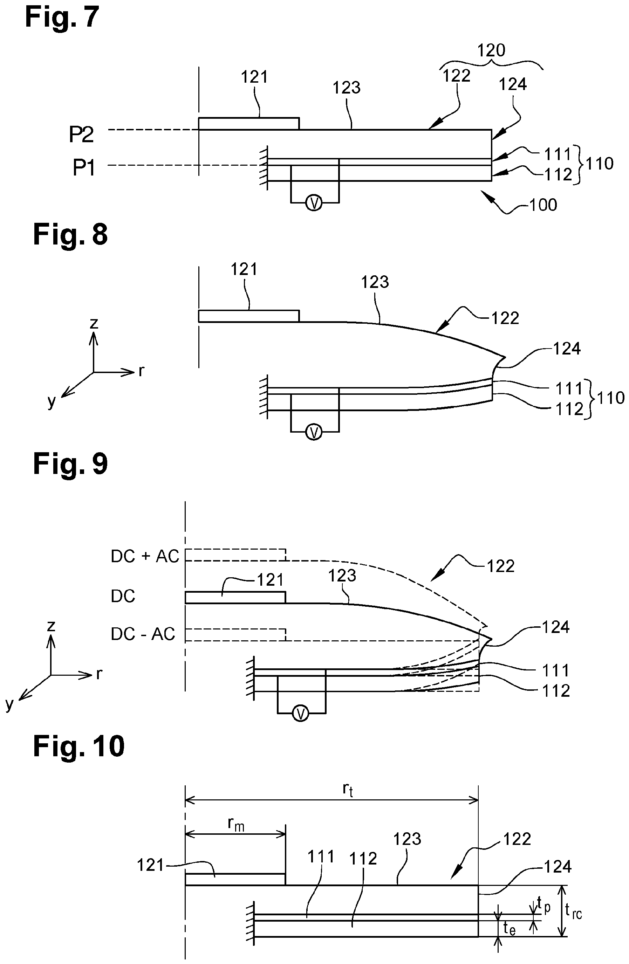

Un exemple d'un haut-parleur MEMS selon l'invention est représenté selon une vue schématique en coupe sur la figure 7. Ce haut-parleur MEMS 100, conçu pour générer des ondes sonores audibles à l'oreille humaine, comporte un système d'actionnement bilame 110 et une capsule d'amplification 120 fixés l'un à l'autre par leurs périphéries.

Selon certains modes de réalisation, le système d'actionnement bilame 110 et la capsule d'amplification 120 sont montés selon une configuration axisymétrique. Dans ces modes de réalisation, le système d'actionnement bilame 110 et la capsule d'amplification 120 comportent tous deux une forme sensiblement circulaire avec, au repos, un diamètre extérieur sensiblement identique. Ils sont alors fixés circonférentiellement l'un à l'autre.

Dans d'autres modes de réalisation, décrits en détail ultérieurement, le système d'actionnement bilame 110 et la capsule d'amplification 120 ont des formes différentes et forment une configuration non axisymétrique. Dans ces modes de réalisation, la capsule d'amplification 120 peut, par exemple, être circulaire et le système d'actionnement bilame 110 rectangulaire.

Le système d'actionnement bilame 110 comporte un actionneur 111 intégré à une couche d'un matériau élastique 112 lui offrant un effet bilame. L'actionneur 111 peut être, par exemple un actionneur piézoélectrique, réalisé par exemple en Titano-Zirconate de Plomb (PZT), en Nitrure d'aluminium (AIN), en Niobate de Lithium (LNO) ou en tout autre substrat adapté à la technologie piézoélectrique. Le matériau piézoélectrique dans lequel est principalement réalisé cet actionneur 111 est appliqué, dans le haut-parleur, en une couche appelée, par mesure de simplicité, couche de matériau piézoélectrique ou couche piézoélectrique. L'actionneur 111 est intégré à une couche d'un matériau élastique 112 comme du Silicium, de l'Oxyde, ou tout autre matériau adapté à la microfabrication d'un bilame ; la couche piézoélectrique peut être appliquée sur la couche élastique 112, par exemple, par dépôt chimique ou par report de couche.

Ce système d'actionnement bilame 110 présente non seulement les avantages de la technologie piézoélectrique décrite précédemment, mais il permet aussi un déplacement de l'actionneur qui vient se combiner au déplacement de la membrane 122 de la capsule d'amplification 120, comme décrits plus en détail par la suite.

La capsule d'amplification 120 comporte une membrane 122 constituant la membrane acoustique du haut-parleur. Au repos, c'est-à-dire lorsque le haut-parleur ne fonctionne pas, la membrane 122 s'étend suivant un plan P2, sensiblement parallèle au plan P1 dans lequel s'étend le système d'actionnement bilame 110, les plans P1 et P2 s'étendant suivant les axes r et y du repère (r,y,z).

La membrane 122 comporte une zone intérieure 121, rigide, et une zone extérieure 123, flexible, la zone intérieure étant la partie centrale de la membrane, par opposition à sa partie excentrée. La membrane 122 présente donc un premier coefficient de rigidité k1 dans sa zone centrale 121 et un second coefficient de rigidité k2 dans sa zone excentrée 123, avec k1 > k2. Pour cela, la zone centrale 121 et la zone excentrée 123 de la membrane 122 peuvent être formées du même matériau, par exemple du silicium (Si), déposé en une couche plus épaisse dans la zone centrale que dans la zone excentrée de sorte à engendrer une rigidité différente.

La capsule d'amplification 120 comporte également une paroi de couplage 124 située à la périphérie de la membrane 122. Cette paroi de couplage 124 s'étend perpendiculairement aux plans P1 et P2, lorsqu'elle est en position de repos, c'est-à-dire lorsque le haut-parleur est hors tension. La paroi de couplage 124 peut être formée dans le même matériau que la membrane 122, par exemple fabriquée d'une seule pièce avec ladite membrane 122 ; elle peut au contraire être formée d'un matériau différent et être rapportée sur la membrane, par exemple par collage. La paroi de couplage 124 comporte une première extrémité s'étendant perpendiculairement au plan P2, à la périphérie de la membrane 122, et une seconde extrémité fixée sur le système d'actionnement bilame 110, à la périphérie dudit système. La paroi de couplage 124 est l'unique point de contact entre la membrane 122 et le système d'actionnement bilame 110. En position de repos, la paroi de couplage 124 s'étend depuis l'extrémité extérieure de la membrane 122 jusqu'au système d'actionnement bilame 110, perpendiculairement au plan P2 de la membrane 122.

Comme représenté sur la figure 7, une source d'alimentation électrique, référencée V, est connectée à deux électrodes de l'actionneur 111 pour fournir une tension d'actionnement. Ces électrodes peuvent par exemple être disposées sous et sur la couche de substrat, ou couche piézoélectrique, de l'actionneur 111.

Sous l'effet de la tension d'actionnement appliquée entre les deux électrodes, l'actionneur 111 se déforme radialement, suivant l'axe r du repère rz. La couche piézoélectrique étant solidaire de la couche élastique 112, une déformation apparaît suivant l'axe z, induite par l'effet bilame. En effet, l'effet bilame du système d'actionnement bilame 110 transforme le déplacement longitudinal de la couche piézoélectrique de l'actionneur 111 en une flexion suivant l'axe z. Par ailleurs, compte tenu de la forme de la membrane 122, la partie rigide 121 de la membrane 122 est libre uniquement sur l'axe z. Le moment de flexion généré par la paroi de couplage 124 reliant l'actionneur 111 à la partie flexible 123 de la membrane est transformé en une translation de la partie rigide 121 de ladite membrane le long de l'axe z. Un exemple de la déformation du système d'actionnement bilame 110 et de la capsule d'amplification 120 est représenté schématiquement sur la figure 8.

On comprend donc que le déplacement généré par la capsule d'amplification 120 s'additionne au déplacement généré par l'actionneur 111, offrant un déplacement total supérieur à celui d'un système d'actionnement bilame classique. Même si le fait que la partie centrale rigide 121 de la membrane 122 diminue le déplacement que pourrait avoir une membrane entièrement flexible, cette partie centrale rigide 121 permet d'améliorer la qualité audio du haut-parleur, en s'approchant du mouvement d'un piston rigide, ce mouvement de piston rigide correspondant au mouvement idéal en termes de son.

La figure 9 représente schématiquement des exemples de déplacements internes du haut-parleur selon l'invention en fonction de la tension d'actionnement appliquée aux électrodes de l'actionneur 111. En effet, contrairement aux haut-parleurs classiques qui peuvent fonctionner avec une tension alternative oscillant autour de 0V, le haut-parleur 100 selon l'invention ne peut fonctionner avec une tension négative. En effet, pour que la capsule d'amplification 120 assure un rôle d'amplificateur quelle que soit la tension aux électrodes de l'actionneur 111, cette tension doit nécessairement être positive. Ainsi, dans la mise en oeuvre du haut-parleur selon l'invention, une tension d'offset à appliquer aux électrodes de l'actionneur 111 est prédéfinie. Cette tension d'offset DC peut être, par exemple, choisie égale à la moitié de la dynamique du signal. Le déplacement est alors une variation du point de repos ainsi obtenu, comme montré dans l'exemple de la figure 9. Dans cet exemple, le signal électrique oscillant varie autour de la tension d'offset DC prédéfinie, la tension oscillante DC-AC correspondant au point de repos et la tension oscillante DC+AC à la déformation maximale du haut-parleur, avec DC > AC. La tension d'offset DC peut par exemple être de 20V et la tension d'oscillation AC de +/- 10V.

La figure 10 représente, selon une vue en demi-coupe, des exemples de dimensions du haut-parleur MEMS des figures 7 à 9. En effet, plusieurs dimensions du haut-parleur 100 peuvent varier et être optimisées en fonction des performances souhaitées. Ces dimensions sont les suivantes :
- Rayon total rₜ de la membrane 122,
- Rayon rₘ de la partie centrale rigide 121 de la membrane,
- Hauteur t_{rc} entre la couche élastique 112 du système d'actionnement bilame 110 et la membrane 122,
- Épaisseur tₚ de la couche piézoélectrique 111 du système d'actionnement bilame 110, et
- Épaisseur tₑ de la couche élastique du système d'actionnement bilame 110.

Chacune de ces dimensions peuvent être modifiées en fonction des performances souhaitées pour le haut-parleur 100. La membrane 122 comporte par exemple un diamètre compris dans un intervalle allant d'environ 100 µm à quelques centimètres. Le rayon total rₜ de la membrane 122 peut ainsi prendre toutes les dimensions comprises entre environ 50 µm et quelques centimètres ; un rayon total de 2 mm peut être considéré comme optimal pour les dispositifs portables actuels.

Le rayon rₘ de la partie centrale rigide 121 de la membrane présente de préférence une longueur de l'ordre de 10 à 60% du rayon rₜ de la membrane. Plus le rayon de la partie centrale rigide est grand, meilleure est la réponse en fréquence du haut-parleur. Un rayon rₘ optimal peut, par exemple, être de l'ordre de 1,10 mm pour un rayon total rₜ de 2 mm. L'épaisseur de la partie centrale rigide de la membrane peut être, par exemple, d'environ 20 µm et l'épaisseur de la partie excentrée flexible d'environ 5 µm.

L'épaisseur de la couche élastique tₑ doit être choisie suffisamment petite pour permettre un grand déplacement de l'actionneur 111, mais suffisamment épaisse pour fournir suffisamment de force pour déformer la partie excentrée flexible 123 de la membrane. L'épaisseur de la couche élastique tₑ peut, par exemple, être de 5 µm pour une épaisseur tₚ de la couche piézoélectrique 111 par exemple de 2 µm, l'épaisseur totale optimale du système d'actionnement bilame 110 étant alors d'environ 7 µm.

La hauteur t_{rc} entre la couche élastique 112 du système d'actionnement bilame 110 et la membrane 122 doit être choisie suffisamment grande pour permettre la flexion de la partie excentrée flexible 123 de la membrane mais suffisamment rigide pour guider celle-ci correctement. Cette hauteur t_{rc} contribue au volume occupé par le haut-parleur et détermine la hauteur de la paroi de coupage 124 de la capsule d'amplification 120. La hauteur t_{rc} peut, par exemple, être de 20 µm pour les exemples d'épaisseurs tₑ et tₚ indiquées précédemment.

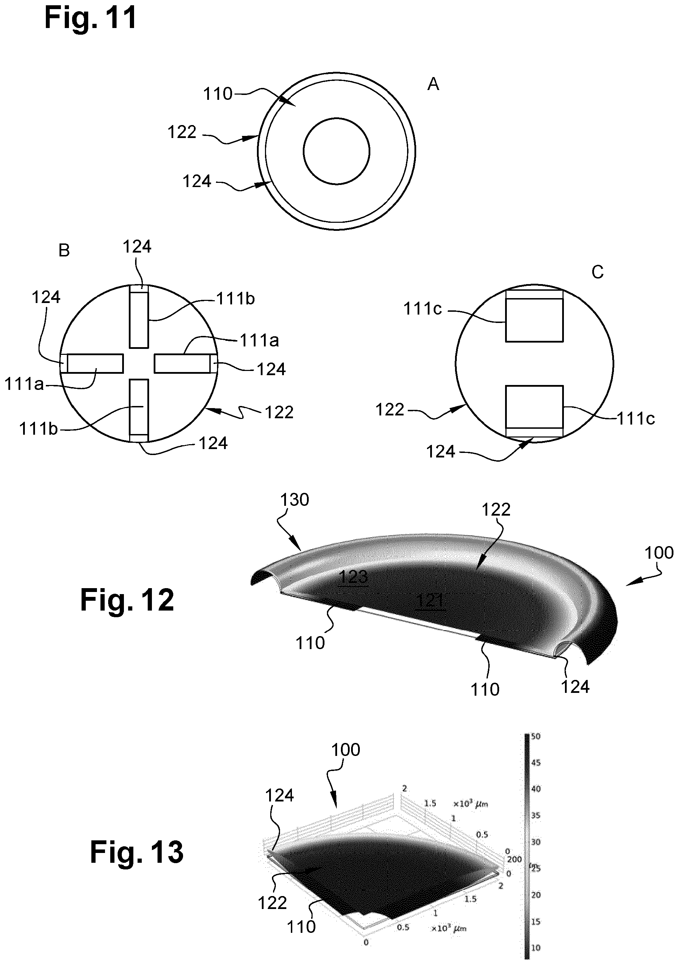

Des exemples, selon des vues de dessous schématiques, du haut-parleur MEMS selon l'invention sont représentés sur la figure 11. La partie A de la figure 11 montre un exemple d'une configuration axisymétrique du haut-parleur 100. Les parties B et C de la figure 11 montrent des exemples d'une configuration non axisymétrique du haut-parleur 100. Dans l'exemple de la partie A, la membrane 122 a une forme de disque dont la partie centrale est rigide et la partie excentrée est flexible ; le système d'actionnement bilame 110 a une forme d'anneau dont le diamètre extérieur, en position de repos, est égal au diamètre extérieur de la membrane 122. La zone de circonférence de la membrane 122 et celle du système d'actionnement bilame 110 sont couplées par la paroi de couplage 124. L'épaisseur de cette paroi de couplage 124 est choisie en fonction de la flexion voulue pour ladite paroi de couplage, comme expliqué précédemment.

La figure 12 représente une vue en coupe d'un haut-parleur 100 selon le mode de réalisation de la partie A de la figure 11. Elle montre de façon plus précise une moitié de haut-parleur avec son système d'actionnement bilame 110 annulaire et sa membrane circulaire 122, montés sur un dispositif de suspension 130, dont les caractéristiques et propriétés sont connues de l'homme du métier et donc pas décrites ici. La figure 12 montre, en particulier, la partie centrale rigide 121 et la partie excentrée flexible 123 de la membrane 122 dont la zone de circonférence est solidaire de la paroi de couplage 124.

La figure 13 montre un exemple du déplacement total obtenu dans un haut-parleur MEMS selon le mode de réalisation des figures 11A et 12. Selon l'échelle colorimétrique associée à la figure 13, un déplacement d'environ 35 à 50 µm peut être obtenu pour la membrane 122 du haut-parleur 100 et un déplacement d'environ 10 à 25 µm peut être obtenu pour le système d'actionnement bilame 110, ces deux déplacements étant additionnés l'un à l'autre.

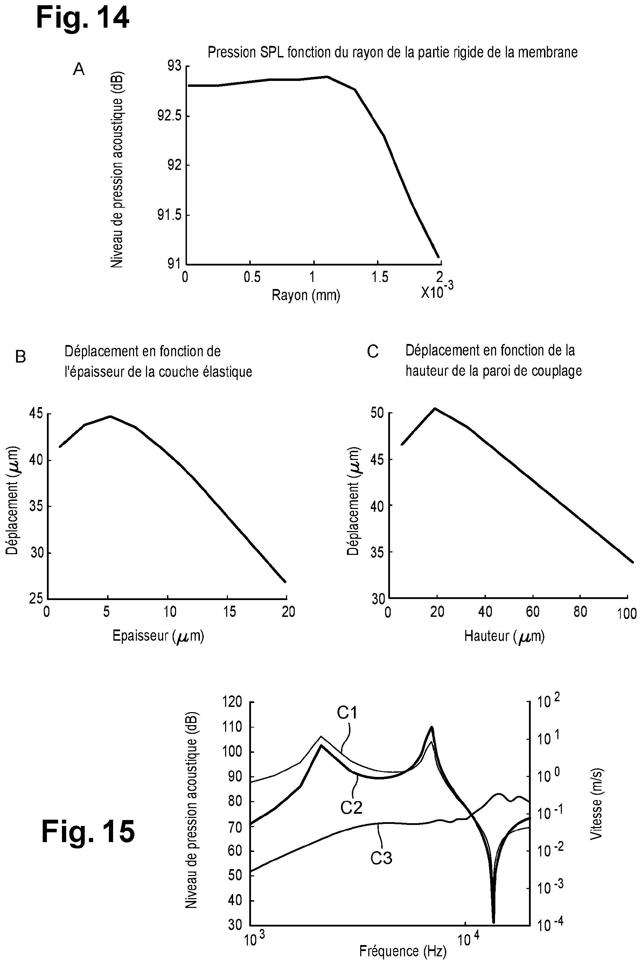

Dans l'exemple du haut-parleur MEMS selon le mode de réalisation des figures 11A et 12 où le système d'actionnement bilame a une forme annulaire, le rayon rₘ de la partie centrale rigide 121 de la membrane peut être optimisé en estimant la pression acoustique (SPL ou PA) en fonction dudit rayon rₘ, avec un rayon total rₜ de la membrane 122 fixe et une fréquence de résonance considérée constante. Un exemple de l'évolution de la pression acoustique SPL, en dB, est représenté sur la courbe A de la figure 14, en fonction du rayon de la partie centrale rigide, en mm, pour une fréquence de résonance et un rayon total de la membrane constants. Plus le rayon de la partie centrale rigide est grand, meilleure est la réponse en fréquence jusqu'à un rayon d'environ 1,10 mm qui semble être la valeur optimum pour le jeu de dimensions choisi.

Les courbes B et C de la figure 14 montrent des évolutions du déplacement total du haut-parleur, en µm, en fonction, respectivement, de l'épaisseur de la couche élastique 112 du système d'actionnement bilame 110 et de la hauteur de la paroi de couplage 124, pour une membrane dont le rayon total est de 2 mm et une couche piézoélectrique 111 dont l'épaisseur est de 2 µm. Ces courbes montrent que, dans cet exemple, l'épaisseur optimale de la couche élastique 112 est d'environ 5 µm et la hauteur optimale de la paroi de couplage 124 est d'environ 20 µm, les valeurs optimales étant les valeurs qui permettent le plus grand déplacement du haut-parleur.

Les exemples précédemment décrits correspondent à un haut-parleur dont la membrane 122 a une forme de disque et le système d'actionnement bilame 110 en forme d'anneau. Le système d'actionnement bilame 110 peut toutefois avoir d'autres formes, comme par exemple une forme rectangulaire. Des exemples de haut-parleur dans lesquels le système d'actionnement bilame est rectangulaire sont représentés sur les parties B et C de la figure 11. Dans ces exemples, la membrane 122 a une forme de disque et le système d'actionnement bilame 110 comporte une ou plusieurs paires d'actionneurs 111 dont la forme, en position de repos, est sensiblement rectangulaire. Les actionneurs 111 peuvent, par exemple, se présenter sous la forme de poutres partiellement encastrées ou de méandres. Les actionneurs 111 de chaque paire d'actionneurs 111a, 111b, 111c sont positionnés face à face, en regard l'un de l'autre, de façon diamétralement opposée, à une distance prédéterminée l'un de l'autre. Chaque actionneur 111, intégré dans une couche élastique 112 correspondante de même forme et même dimensions que ledit actionneur, présente une longueur inférieure ou égale au rayon total rₜ de la membrane 122. Dans les exemples B et C de la figure 11, les actionneurs des paires d'actionneurs 111a, 111b, 111c sont positionnés à distance l'un de l'autre ; toutefois, l'homme du métier comprendra que les actionneurs d'une paire d'actionneurs peuvent être juxtaposés l'un à l'autre et former, en position de repos, une ligne d'actionneurs traversant la membrane de part en part.

Quelles que soient les dimensions des actionneurs, les actionneurs d'une même paire sont de dimensions identiques et sont couplés chacun à la membrane 122 par une paroi de couplage 124 dont l'épaisseur définit le niveau de flexion de ladite paroi et dont la largeur est identique à la largeur de l'actionneur correspondant. Comme dans l'exemple A où l'actionneur est de forme annulaire, la paroi de couplage 124 des exemples B et C de la figure 11 peut être réalisée dans le même matériau que la membrane 122 et fabriquée d'un seul tenant avec ladite membrane ou, au contraire, être réalisée dans un matériau différent et rapportée sur la membrane et l'actionneur, par exemple par collage.

Dans les exemples B et C de la figure 11, la configuration du haut-parleur n'est pas axisymétrique de sorte que la déformation de la membrane peut varier et être inégale ou dissymétrique sur toute sa surface. Autrement dit, toute la surface de la membrane ne se déplace pas de manière régulière et identique, ce qui offre l'avantage d'une plus grande souplesse du haut-parleur, c'est-à-dire d'une raideur relativement faible.

Une estimation de la pression acoustique SPL, générée par le haut-parleur MEMS selon l'invention, peut être calculée à partir de la vitesse au point central de la membrane 122, par exemple au moyen d'un logiciel de modélisation comme le logiciel COMSOL Multiphysics^{®}. Un exemple d'une telle estimation est représenté sur la figure 15 où la courbe C1 représente, en fonction de la fréquence en Hz, la vitesse du haut-parleur selon l'invention au centre de la membrane, C2 représente la pression acoustique SPL estimée pour ce haut-parleur et C3 représente la pression acoustique d'un haut-parleur selon l'art antérieur et, en particulier, le haut-parleur divulgué dans le brevet US 2017/0094418 A1. Les courbes de la figure 15 montrent que, bien qu'elle soit un peu accidentée, la pression acoustique du haut-parleur MEMS selon l'invention est nettement supérieure à celle du haut-parleur selon l'art antérieur.

Le haut-parleur MEMS tel que décrit précédemment présente non seulement l'avantage d'être miniaturisé, mais il présente également l'avantage de pouvoir être obtenu par microfabrication. On appelle « microfabrication » la fabrication d'un microsystème au moyen d'une succession d'étapes de dépôt, photolithographie et/ou gravure d'un substrat tel qu'une plaquette de silicium (aussi appelée wafer).

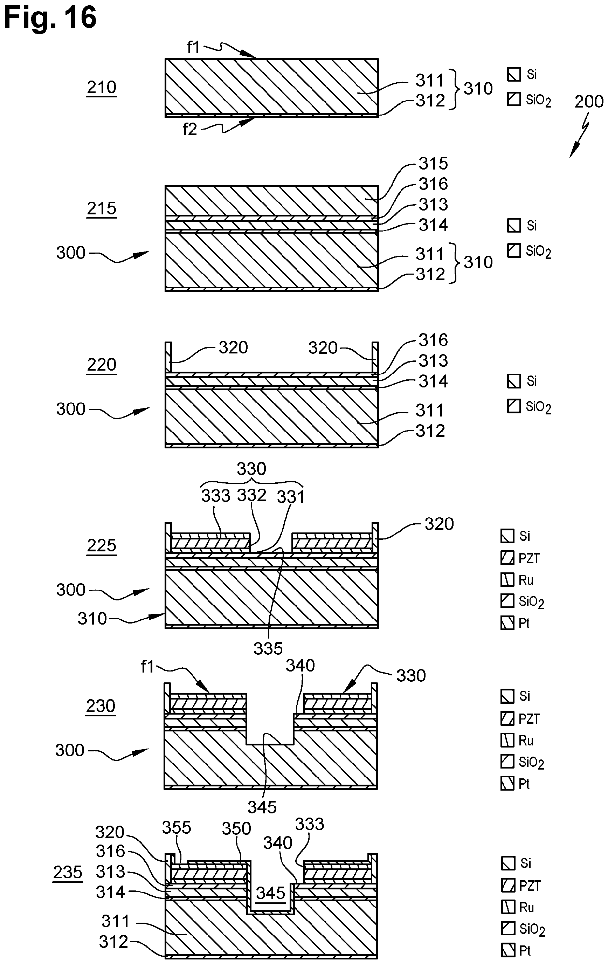

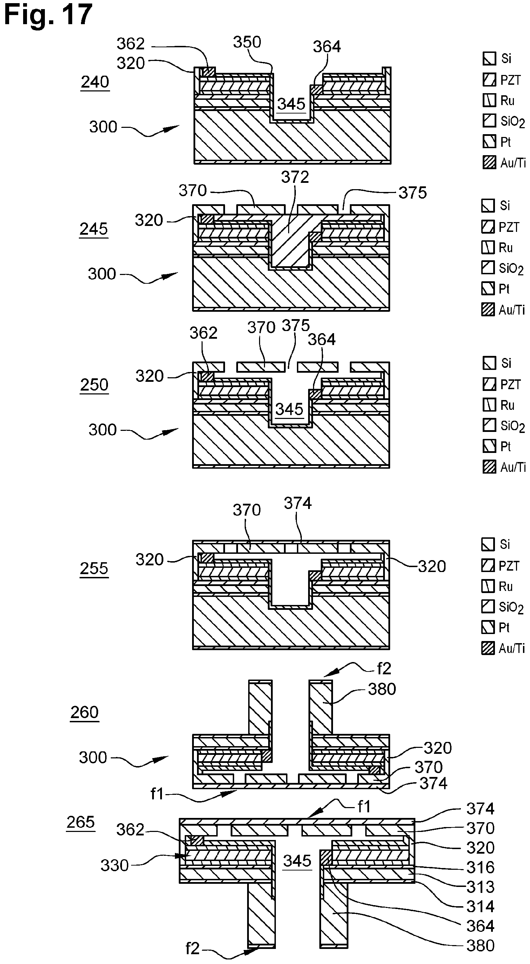

Un exemple des différentes étapes du procédé 200 de microfabrication d'un haut-parleur selon le mode de réalisation des figures 11A et 12 est représenté sur les figures 16 et 17, les étapes 240 à 265 représentées en figure 17 étant réalisées à la suite des étapes 210 à 235 représentées en figure 16. Sur ces figures 16 et 17, le haut-parleur en cours de fabrication, appelé composant 300, est représenté selon des vues en coupe. Pour rappel, dans ce mode de réalisation, la membrane et la paroi de couplage sont circulaires et le système d'actionnement bilame est annulaire.

Le procédé 200 de microfabrication comporte une première étape 210 de choix d'un substrat 310. Ce substrat 310 peut être, par exemple, un substrat en silicium 311 muni d'une couche d'oxydation 312 sur la face arrière f2. Le procédé 200 comporte ensuite une deuxième étape 215 de dépôt, sur la face avant f1, de couches d'oxydation (SiO2) et de silicium polycristallin, ou polysilicium (polySi). Cette étape comporte le dépôt de deux couches 314, 316 de SiO₂, entre lesquelles sont intercalées deux couches 313, 315 de polySi. Le dépôt de ces couches 313 à 316 peut être réalisé soit en déposant chimiquement les couches les unes sur les autres (une couche de SiO2 puis une couche de polySi, etc.), soit en collant de fines plaquettes (appelées wafers) de SiO₂ et polySi les unes sur les autres.

Le procédé comporte ensuite une étape 220 de photolithographie de la face avant f1. Cette étape 220 consiste à graver la couche 315 de polySi supérieure, jusqu'à la couche d'oxydation 316, afin d'y dessiner la paroi de couplage 320.

L'étape suivante (étape 225) consiste à déposer, à l'intérieur de la paroi de couplage 320, les couches destinées à former l'actionneur piézoélectrique 330. Ces couches comportent au moins un matériau piézoélectrique et, de préférence, des couches de métaux inertes adaptées pour former des électrodes. Ces couches peuvent, par exemple, être une couche 331 métallique (par exemple du platine (Pt)), une couche 332 de matériau piézoélectrique (par exemple du PZT) et une couche 333 métallique (par exemple du ruthénium (Ru)), les couches 331 et 333 étant conçues pour former les électrodes de contact de l'actionneur piézoélectrique. Ces couches 331, 332, 333 sont déposées de sorte à ne pas recouvrir le centre 335 du substrat. Pour cela, les trois couches 331, 332, 333 peuvent être déposées chimiquement et le centre retiré par gravure de l'empilement des trois couches ; en variante, les trois couches 331, 332, 333 peuvent être collées ou reportées les unes sur les autres. L'empilement de ces trois couches 331, 332, 333 est destiné à former l'actionneur piézoélectrique 330 qui, intégré aux couches 313, 314, 316 de SiO₂ et polySi formera le système d'actionnement bilame.

Le procédé 200 comporte ensuite une étape 230 de photolithographie de la face avant f1 consistant en une gravure sèche des couches 313, 314 et 316 de SiO₂ et polySi et une gravure partielle de la couche 311 de silicium. Cette étape 230 est prévue pour générer une cavité 345 qui donnera sa forme annulaire au système d'actionnement bilame. Cette cavité 345 comporte une dénivellation 340 entre l'empilement de couches 331, 332, 333 et la couche d'oxydation 316, cette dénivellation 340 ayant pour but de permettre un accès à la couche de matériau piézoélectrique 332.

L'étape suivante 235 comporte le dépôt d'un masque de protection 350, par exemple un nitrure, comme un nitrure de titane, un nitrure de tantale ou tout autre nitrure assurant une protection du matériau piézoélectrique, sur toute la surface du composant 300, excepté aux emplacements destinés au contact des électrodes. Plus précisément, le masque de protection 350 est déposé de sorte à recouvrir la paroi de couplage 320, la couche 333 de Ru et toute la zone gravée, sauf la dénivellation 340 et une zone prédéfinie 355 de la couche 333 de Ru.

L'étape suivante 240 consiste à déposer les pistes et/ou plots de connexion métalliques 362, 364, par exemple en or (Au) ou en titane (Ti), qui permettront l'application de la tension électrique sur l'actionneur piézoélectrique.

Les étapes suivantes 245,250 et 255 sont les étapes de fabrication de la membrane 370 du haut-parleur. L'étape 245 consiste à remplir la cavité 345 obtenue aux étapes 225 et 230 avec une couche sacrificielle 372, par exemple en SiO₂ ; ce remplissage est prévu pour recouvrir toute la cavité 345 ainsi que toute la surface du composant 300 entre la paroi de couplage 320 et le plot de connexion 362 afin de créer une surface plane et lisse sur laquelle peut être déposée la membrane 370. La membrane 370, déposée sur la couche sacrificielle 372, est équipée de trous 375 permettant, une fois la membrane déposée, de supprimer la couche sacrificielle 372 (étape 250), par exemple au moyen d'acide fluorhydrique. Un dépôt d'un oxyde non conforme 374 est ensuite effectué au-dessus de la membrane 370 afin de reboucher les trous 375 de ladite membrane 370.

Dans une variante (non représentée sur les figures), la membrane 270 est réalisée séparément du composant 300, puis rapportée et collée sur ledit composant, en porte-à-faux sur la paroi de couplage 320. Bien que plus délicate à réaliser, cette variante permet d'éviter le dépôt et la suppression d'une couche sacrificielle.

Quelle que soit la variante choisie, la membrane 370 comporte une épaisseur qui varie du centre vers l'extérieur de ladite membrane, cette variation d'épaisseur engendrant la partie centrale rigide et la partie excentrée flexible de la membrane.

Après réalisation de la membrane 370, le procédé 200 comporte une opération 260 de gravure profonde de la face arrière f2 du composant 300. Le composant 300 est retourné et sa face arrière f2 est gravée sur toute la hauteur du substrat 310 de sorte à libérer le système d'actionnement bilame. Seule une couronne 380 du substrat 310 est conservée pour constituer un plot d'ancrage permettant la fixation du haut-parleur.

Le procédé 200 comporte une étape finale 265, dans laquelle le composant 300 fini est retourné et prêt à être monté dans un dispositif portable.

## Revendications

1. Haut-parleur MEMS (100) adapté pour générer des ondes sonores audibles, comportant un système d'actionnement bilame (110) s'étendant suivant un premier plan (P1), comportant en outre une capsule d'amplification (120) comprenant :
- une membrane (122) s'étendant suivant un second plan (P2), parallèle au premier plan, ladite membrane comportant une zone intérieure rigide (121) et une zone extérieure flexible (123), et
- une paroi de couplage (124) rigide, fixée en périphérie du système d'actionnement bilame (110) pour rendre la zone extérieure flexible (123) de la membrane solidaire dudit système d'actionnement et, sous l'effet d'une tension électrique d'actionnement appliquée au système d'actionnement bilame, générer sur la paroi de couplage un moment de flexion entraînant une translation de la zone intérieure rigide (121) de ladite membrane.

2. Haut-parleur selon la revendication 1, **caractérisé en ce que** le système d'actionnement bilame (110) comporte au moins un actionneur piézoélectrique (111) intégré à une couche d'un matériau élastique (112).

3. Haut-parleur selon la revendication 1 ou 2, **caractérisé en ce que** la capsule d'amplification (120) et le système d'actionnement bilame (110) sont de formes circulaires avec, au repos, un diamètre extérieur identique.

4. Haut-parleur selon la revendication 3, **caractérisé en ce que** le système d'actionnement bilame (110) est de forme annulaire.

5. Haut-parleur selon la revendication 1 ou 2, **caractérisé en ce que** la capsule d'amplification (120) a une forme de disque et **en ce que** le système d'actionnement bilame (110) comporte au moins une paire d'actionneurs de formes rectangulaires, les actionneurs de chaque paire étant positionnés en regard l'un de l'autre, de façon diamétralement opposée.

6. Haut-parleur selon l'une quelconque des revendications 1 à 5, **caractérisé en ce que** la zone intérieure rigide (121) de la membrane (122) présente un rayon compris entre environ 10 à 60% du rayon total de la membrane.

7. Haut-parleur selon l'une quelconque des revendications 1 à 6, **caractérisé en ce que** la membrane (122) comporte un diamètre compris entre environ 100 µm et quelques centimètres.

8. Haut-parleur selon l'une quelconque des revendications 1 à 7, **caractérisé en ce que** la membrane (122) et la paroi de couplage (124) de la capsule d'amplification sont réalisées d'une seule pièce dans un même matériau.

9. Haut-parleur selon l'une quelconque des revendications 1 à 7, **caractérisé en ce que** la membrane (122) et la paroi de couplage (124) de la capsule d'amplification sont réalisées dans des matériaux différents, la paroi de couplage étant collée à une extrémité extérieure de la zone extérieure flexible (123) de la membrane.

10. Procédé de microfabrication d'un haut-parleur MEMS selon l'une quelconque des revendications 1 à 9, comportant les étapes suivantes :
a) Choix d'un substrat (310) ;
b) Dépôt, sur une face avant (f1) du substrat, d'au moins une couche d'oxydation (314, 316) et une couche de polysilicium (313, 315) ;
c) Gravure, sur la face avant (f1), de la paroi de couplage (124) par photolithographie ;
d) Dépôt d'au moins une couche piézoélectrique (332) pour former l'actionneur ;
e) Gravure, au centre de la couche piézoélectrique (332) et des couches d'oxydation (314, 316) et de polysilicium (313), d'une cavité (345) ;
f) Dépôt d'un masque de protection (350) recouvrant partiellement des parois de la cavité (345) et la surface de la couche piézoélectrique (332) ;
g) Dépôt de pistes et/ou plots de connexion (362, 364) dans des zones non recouvertes par le masque de protection (350) ;
h) Dépôt d'une membrane (370) en appui sur la paroi de couplage (320) ;
i) Gravure, sur une face arrière (f2) du substrat, d'un plot d'ancrage (380).

11. Procédé selon la revendication 10, **caractérisé en ce que** la couche piézoélectrique (332) est une couche de matériau piézoélectrique associée à deux couches d'au moins un métal inerte (331, 333) adaptées pour constituer des électrodes.

12. Procédé selon la revendication 10 ou 11, **caractérisé en ce que** la cavité (345) gravée à l'étape e) comporte une dénivellation (340) conçue pour constituer une connexion électrique à la couche piézoélectrique.

13. Procédé selon l'une quelconque des revendications 10 à 12, **caractérisé en ce que** la membrane (370) est déposée sur une couche sacrificielle (372) recouvrant une zone s'étendant à l'intérieur de la paroi de couplage (320), la membrane (370) étant munie de trous (375) adaptés pour supprimer ladite couche sacrificielle (372).

## Patentansprüche

1. MEMS-Lautsprecher (100), der dazu geeignet ist, hörbare Schallwellen zu erzeugen, mit einem Bimetall-Betätigungssystem (110), das sich entlang einer ersten Ebene (P1) erstreckt, ferner mit einer Verstärkungskapsel (120), die umfasst:
- eine Membran (122), die sich entlang einer zweiten Ebene (P2) parallel zur ersten Ebene erstreckt, wobei die Membran einen starren Innenbereich (121) und einen flexiblen Außenbereich (123) aufweist, und
- eine starre Kopplungswand (124), die am Umfang des Bimetall-Betätigungssystems (110) befestigt ist, um den flexiblen Außenbereich (123) der Membran mit dem Betätigungssystem fest zu verbinden und unter der Wirkung einer an das Bimetall-Betätigungssystem angelegten elektrischen Betätigungsspannung an der Kopplungswand ein Biegemoment zu erzeugen, das eine Translation des starren Innenbereichs (121) der Membran bewirkt.

2. Lautsprecher nach Anspruch 1, **dadurch gekennzeichnet, dass** das Bimetall-Betätigungssystem (110) mindestens ein piezoelektrisches Stellglied (111) aufweist, das in eine Schicht aus einem elastischen Material (112) eingebettet ist.

3. Lautsprecher nach Anspruch 1 oder 2, **dadurch gekennzeichnet, dass** die Verstärkerkapsel (120) und das Bimetall-Betätigungssystem (110) kreisförmige Formen mit im Ruhezustand identischem Außendurchmesser aufweisen.

4. Lautsprecher nach Anspruch 3, **dadurch gekennzeichnet, dass** das Bimetall-Betätigungssystem (110) ringförmig ist.

5. Lautsprecher nach Anspruch 1 oder 2, **dadurch gekennzeichnet, dass** die Verstärkerkapsel (120) eine Scheibenform hat und dass das Bimetall-Betätigungssystem (110) mindestens ein Paar rechteckig geformter Stellglieder umfasst, wobei die Stellglieder jedes Paars einander gegenüberliegend und diametral positioniert sind.

6. Lautsprecher nach einem der Ansprüche 1 bis 5, **dadurch gekennzeichnet, dass** der starre Innenbereich (121) der Membran (122) einen Radius von etwa 10 bis 60% des Gesamtradius der Membran aufweist.

7. Lautsprecher nach einem der Ansprüche 1 bis 6, **dadurch gekennzeichnet, dass** die Membran (122) einen Durchmesser zwischen etwa 100 µm und einigen Zentimetern aufweist.

8. Lautsprecher nach einem der Ansprüche 1 bis 7, **dadurch gekennzeichnet, dass** die Membran (122) und die Kopplungswand (124) der Verstärkerkapsel einstückig aus demselben Material hergestellt sind.

9. Lautsprecher nach einem der Ansprüche 1 bis 7, **dadurch gekennzeichnet, dass** die Membran (122) und die Kopplungswand (124) der Verstärkerkapsel aus unterschiedlichen Materialien hergestellt sind, wobei die Kopplungswand an ein äußeres Ende des flexiblen Außenbereichs (123) der Membran geklebt ist.

10. Verfahren zur Mikrofabrikation eines MEMS-Lautsprechers nach einem der Ansprüche 1 bis 9, das die folgenden Schritte umfasst:
a) Auswahl eines Substrats (310);
b) Aufbringen mindestens einer Oxidationsschicht (314, 316) und einer Polysiliziumschicht (313, 315) auf einer Vorderseite (f1) des Substrats;
c) Ätzen der Kopplungswand (124) auf der Vorderseite (f1) durch Fotolithografie;
d) Aufbringen mindestens einer piezoelektrischen Schicht (332), um das Stellglied zu bilden;
e) Ätzen eines Hohlraums (345) in der Mitte der piezoelektrischen Schicht (332) und der Oxidationsschichten (314, 316) und der Polysiliziumschicht (313);
f) Aufbringen einer Schutzmaske (350), die teilweise die Wände des Hohlraums (345) und die Oberfläche der piezoelektrischen Schicht (332) bedeckt;
g) Aufbringen von Leiterbahnen und/oder Verbindungskontakten (362, 364) in Bereichen, die nicht von der Schutzmaske (350) bedeckt sind;
h) Aufbringen einer Membran (370), die an der Kopplungswand (320) anliegt
i) Ätzen, auf einer Rückseite (f2) des Substrats, eines Verankerungskontakts (380).

11. Verfahren nach Anspruch 10, **dadurch gekennzeichnet, dass** die piezoelektrische Schicht (332) eine Schicht aus piezoelektrischem Material ist, die mit zwei Schichten aus mindestens einem inerten Metall (331, 333) verbunden ist, die geeignet sind, Elektroden zu bilden.

12. Verfahren nach Anspruch 10 oder 11, **dadurch gekennzeichnet, dass** der in Schritt e) geätzte Hohlraum (345) eine Unebenheit (340) aufweist, die so gestaltet ist, dass sie eine elektrische Verbindung zur piezoelektrischen Schicht bildet.

13. Verfahren nach einem der Ansprüche 10 bis 12, **dadurch gekennzeichnet, dass** die Membran (370) auf eine Opferschicht (372) aufgebracht wird, die einen Bereich bedeckt, der sich innerhalb der Kopplungswand (320) erstreckt, wobei die Membran (370) mit Löchern (375) versehen ist, die zum Entfernen der Opferschicht (372) geeignet sind.

## Claims

1. MEMS speaker (100) suitable for generating audible sound waves, comprising a bimetallic strip actuation system (110) extending in a first plane (P1) further comprising an amplification capsule (120) comprising:
- a membrane (122) extending in a second plane (P2), parallel to the first plane, said membrane comprising a rigid interior zone (121) and a flexible exterior zone (123), and
- a rigid coupling wall (124), fastened at the periphery of the bimetallic strip actuation system (110) to make the flexible exterior zone (123) of the membrane integral with said actuation system and, under the effect of an actuation electric voltage applied to the bimetallic strip actuation system, generate on the rigid coupling wall a bending moment resulting in a translation of the rigid interior zone (121) of said membrane.

2. Speaker according to claim 1, **characterised in that** the bimetallic strip actuation system (110) comprises at least one piezoelectric actuator (111) integrated into a layer of an elastic material (112).

3. Speaker according to claim 1 or 2, **characterised in that** the amplification capsule (120) and the bimetallic strip actuation system (110) are of circular shaped with, at rest, an identical outer diameter.

4. Speaker according to claim 3, **characterised in that** the bimetallic strip actuation system (110) is of annular shape.

5. Speaker according to claim 1 or 2, **characterised in that** the amplification capsule (120) has a disc shape and **in that** the bimetallic strip actuation system (110) comprises at least one pair of rectangular-shaped actuators, the actuators of each pair being positioned facing one another, diametrically opposite.

6. Speaker according to any of claims 1 to 5, **characterised in that** the rigid interior zone (121) of the membrane (122) has a radius comprised between about 10 to 60% of the total radius of the membrane.

7. Speaker according to any of claims 1 to 6, **characterised in that** the membrane (122) comprises a diameter comprised between about 100 µm and a few centimetres.

8. Speaker according to any of claims 1 to 7, **characterised in that** the membrane (122) and the coupling wall (124) of the amplification capsule are made from one single piece in the same material.

9. Speaker according to any of claims 1 to 7, **characterised in that** the membrane (122) and the coupling wall (124) of the amplification capsule are made from different materials, the coupling wall being glued to an exterior end of the flexible exterior zone (123) of the membrane.

10. Method of microfabrication of a MEMS speaker according to any of claims 1 to 9, comprising the following steps:
a) Choosing a substrate (310);
b) Deposition, on a front face (f1) of the substrate, of at least one oxidation layer (314, 316) and a polysilicon layer (313, 315);
c) Etching, on the front face (f1), of the coupling wall (124) via photolithography;
d) Deposition of at least one piezoelectric layer (332) to form the actuator;
e) Etching of a cavity (345), at the centre of the piezoelectric layer (332) and of the layers of oxidation (314, 316) and of polysilicon (313);
f) Deposition of a protection mask (350) partially covering walls of the cavity (345) and the surface of the piezoelectric layer (332);
g) Deposition of tracks and/or connection pads (362, 364) in zones not covered by the protection mask (350);
h) Deposition of a membrane (370) bearing against the coupling wall (320);
i) Etching, on a rear face (f2) of the substrate, of an anchoring pad (380).

11. Method according to claim 10, **characterised in that** the piezoelectric layer (332) is a layer of piezoelectric material associated with two layers of at least one inert metal (331, 333) suitable for forming electrodes.

12. Method according to claim 10 or 11, **characterised in that** the cavity (345) etched in the step e) comprises a drop (340) designed to form an electrical connection to the piezoelectric layer.

13. Method according to any of claims 10 to 12, **characterised in that** the membrane (370) is deposited on a sacrificial layer (372) covering a zone extending inside the coupling wall (320), the membrane (370) being provided with holes (375) suitable for suppressing said sacrificial layer (372).
